# EUROPÄISCHE PATENTSCHRIFT

(11) **EP 1 297 573 B1**
(45) Veröffentlichungstag und Bekanntmachung des Hinweises auf die Patenterteilung: **30.08.2006**
(21) Anmeldenummer: 01984077.6
(22) Anmeldetag: 19.06.2001
(51) Int. Cl.: H01L 27/00, H01L 25/065, G02F 1/1333

(54) **BILDSCHIRM-ELEMENT FÜR EINEN HOCHAUFLÖSENDEN BILDSCHIRM**
SCREEN ELEMENT FOR A HIGH RESOLUTION SCREEN
ELEMENT D'AFFICHAGE POUR AFFICHAGE HAUTE RESOLUTION

(30) Priorität: 24.06.2000 DE 10030949; 26.01.2001 DE 10103496
(43) Veröffentlichungstag der Anmeldung: 02.04.2003
(73) Patentinhaber: Dietz, Hartmut, 72285 Pfalzgrafenweiler (DE)
(72) Erfinder: Dietz, Hartmut, 72285 Pfalzgrafenweiler (DE)
(74) Vertreter: Klocke, Peter
(86) Internationale Anmeldenummer: PCT/DE2001/002238
(87) Internationale Veröffentlichungsnummer: WO 2002/001640

(56) Entgegenhaltungen:
- EP-A- 0 537 529
- WO-A-00/23976

## Beschreibung

Die vorliegende Erfindung betrifft ein Bildschirm-Element sowie eine daraus hergestellte Bildschirm-Fläche sowie ein Verfahren zur Herstellung eines Bildschirmelements für einen hochauflösenden Bildschirm.

Für große Anzeigeflächen ist es bisher nicht möglich, hochauflösende Displays herzustellen. Wird eine große Anzeigefläche benötigt, so kann dies beispielsweise mittels Projektion erreicht werden. Bei der Verwendung von Displays, deren typische Auflösung bei 640 x 480 bis 1024 x 786 Bildpunkten liegt, müssen zur Erhöhung der Auflösung mehrere Geräte nebeneinander und übereinander angeordnet werden. Da alle diese Geräte aber einen Rand haben, ist das sich ergebende Bild in mehrere sichtbare Bereiche geteilt.

Bei der Verwendung eines CRT-Monitors mit einer Auflösung von 1600 x 1280 Bildpunkten ist eine maximale Größe von 24 Zoll Bildschirmdiagonale möglich. Mit der bisherigen Technik bei Flüssigkristallen, können Displays mit einer maximalen Auflösung von 1280 x 1024 Punkten bzw. maximal ca. 20 Zoll wirtschaftlich gefertigt werden. Bekanntlich werden, beispielsweise bei der TFT-Technologie, die einzelnen Punkte über eine Matrix aus horizontalen und vertikalen Leiterbahnen angesteuert. An deren Kreuzungspunkte sitzt ein Transistor, der diesen Punkt aktiviert, sobald auf beiden Leitungen ein Strom fließt. Wenn ein derartiger Transistor defekt ist, kann dieser Punkt nicht mehr angesteuert werden und bleibt dauerhaft dunkel. Bei einem großen Display mit 1280 x 1024 Punkten werden, da jeder Punkt drei Farben benötigt, ca. 4 Millionen Transistoren benötigt. Zur Herstellung werden hochreine Fertigungsräume benötigt, da ein Staubkorn gleich mehrere Transistoren zerstört. Infolgedessen ist der Ausschuss der Displays umso höher, je größer die Fläche wird. Auch hier können nicht einfach mehrere Displays zusammengeschaltet werden, da bei jedem Display auf der Seite die Anschlusspunkte und die Halterung der Frontplatte untergebracht sind. Dadurch entsteht ebenfalls ein Rand bei der Anordnung mehrerer Geräte nebeneinander.

Der vorliegenden Erfindung liegt daher die Aufgabe zugrunde, Möglichkeiten vorzuschlagen, mit denen hochauflösende Großdisplays mit unterbrechungsfreier Displayfläche herstellbar sind.

Diese Aufgabe wird erfindungsgemäß durch ein Bildschirm-Element mit den Merkmalen des Hauptanspruchs gelöst. Weitere vorteilhafte Ausgestaltungen sind den Unteransprüche zu entnehmen.

Die Grundidee der Erfindung liegt darin, das Display aus vielen Folien zusammenzusetzen, wodurch es möglich wird, Leiterbahnen nach hinten abzuführen und damit auch die Anschlusspunkte des Displays nach hinten zu verlagern. Damit wird der seitliche Rand am jeweiligen Display eingespart und die Displays können nahtlos aneinander gereiht werden. Abhängig davon, wie die Beleuchtung der Bildpunkte erfolgt, können die Folien durchsichtig oder undurchsichtig sein. Durchsichtige Folien sind dann anzusetzen, wenn eine Beleuchtung der Bildpunkte aus dem Hintergrund erfolgt, während undurchsichtige Folien dann verwendet werden können, wenn die Bildpunkte selbstleuchtend ausgebildet sind.

Erfindungsgemäß besteht ein Bildschirm-Element aus einem Stapel von mehreren Kunststofffolien-Zuschnitten, die geometrisch in einer bestimmten Art und Weise geformt sein können und aufeinander gelegt sind. Jeder Kunststofffolienzuschnitt weist eine die vordere sichtbare Displayfläche formende Stirnseite, von der Stirnseite sich nach hinten weg erstreckende Seiten und eine die Seite verbindende Rückseite auf. Die sich nach hinten wegerstreckenden Seiten können in einem rechten oder auch einem anderen geeigneten Winkel zu der Stirnseite stehen. Auch die die Seiten verbindende Rückseite kann je nach Ausbildung gerade sein oder einen Radius aufweisen. Im Bereich der Stirnseite befindet sich auf einer ersten flachen Seite des Kunststofffolien-Zuschnittes eine Metallisierung, die als Massepotential für die jeweilige Folie dient. Auf der gegenüberliegenden zweiten Flachseite befinden sich wenigsten im Bereich der Stirnseite metallische, voneinander beabstandete und getrennt elektrisch ansteuerbare Anschlüsse, wobei die Größe der Anschlüsse der Größe des jeweiligen Bildpunktes entsprechen. Dies kann entweder durch entsprechend ausgebildete Anschlussflächen (Pads) oder, bei geeigneter Technik, mittels eines in der Folie angeordneten Loches zur Aufnahme von Flüssigkristall erfolgen. Des weiteren befinden sich auf einem Kunststofffolien-Zuschnitt elektrische Verbindungsleitungen von den Stirnseiten-Anschlüssen auf den Flachseiten zu den Rändern der sich nach hinten von der Stirnseite weg erstreckenden Folienseiten und/oder zur Rückseite. Damit werden die Anschlüsse der Bildpunkte aus dem sichtbaren Bereich nach hinten verlagert. Sofern die Erzeugung der Bildpunkte mittels Flüssigkristall erfolgt, werden, wie vorstehend erwähnt, durchsichtige Folien verwendet. Bei der Bilderzeugung mit selbstleuchtendem Material kann beispielsweise ein organisches lichtemittierendes Polymer (OLEP) verwendet werden. Da dieses selbst leuchtet wird eine undurchsichtige, vorzugsweise schwarze Kunststofffolie verwendet.

Zur Erzeugung eines Bildschirm-Elements werden mehrere dieser Folien übereinandergelegt und verklebt, so dass sich daraus ein Stapel mit bereits einer Vielzahl von Bildpunkten ergibt. Diese Stapel werden aneinander und übereinander aufgereiht, so dass ein beliebig großes Display mit entsprechend benötigter Auflösung zusammengestellt werden kann, ohne dass für den Betrachter die Trennung zwischen den einzelnen Bildschirm-Elementen sichtbar ist und die große Displayfläche als eine Fläche erscheint. Eine derart aufgebaute LCD-Fläche mit durchsichtigen Folien weist dann, abhängig von der Art des verwendeten Flüssigkristalls vor der Displayfläche noch entsprechende zusätzliche Elemente, wie beispielsweise Abstandshalter, Farbfilter, Polfilter, Abdeckscheibe und dgl. auf, um einen geeigneten und kompakten einheitlich erscheinenden Bildschirm zu erzeugen. Hier sind verschiedene, dem Fachmann bekannte Möglichkeiten gegeben. Bei der Verwendung von OLEP benötigt die Displayfläche nur noch einen Rahmen, eine vordere Schutzscheibe und ein hinteres Gehäuse. Der technische Aufwand für Polarisationsfilter, Abstandshalter usw., wie dies für den LCD-Flüssigkristall Bildschirm benötigt wird, entfällt hier.

Die Aufgabe wird außerdem durch ein Verfahren zur Herstellung eines Bildschirm-Elements gelöst, bei dem ein OLEP für die Bildpunkte verwendet wird. Gemäß dem Verfahren wird zur Herstellung eines Bildschirm-Elements ein Stapel aus einzelnen Folienzuschnitten hinsichtlich der Stirnseite gemeinsam behandelt, dann wieder vereinzelt und jede Folie auf der ersten Flachseite (Unterseite) weiter bearbeitet und im Anschluss daran das Bildelement durch Verkleben der einzelnen Folien hergestellt.

Zum besseren Verständnis der Erfindung und der möglichen Abänderungen wird die Erfindung nachfolgend anhand eines Ausführungsbeispiels näher erläutert. Es stellen dar:
- Figur 1: einen Kunststofffolienzuschnitt in der Draufsicht (a), in der Stirnansicht (b) und in der Ansicht von unten (c);
- Figur 2: die perspektivische Ansicht eines Bildschirm-Elements bestehend aus einem Stapel von mehreren Kunststofffolien-Zuschnitten gemäß Figur 1;
- Figur 3: ein Bildschirm-Element gemäß Figur 2 mit einer Anschlussplatine;
- Figur 4: eine LCD-Fläche aus mehreren Bildschirm-Elementen gemäß Figur 3; und
- Figur 5: eine vergrößerte Darstellung eines Ausschnitts einer Folie im Bereich der Stirnseiten.

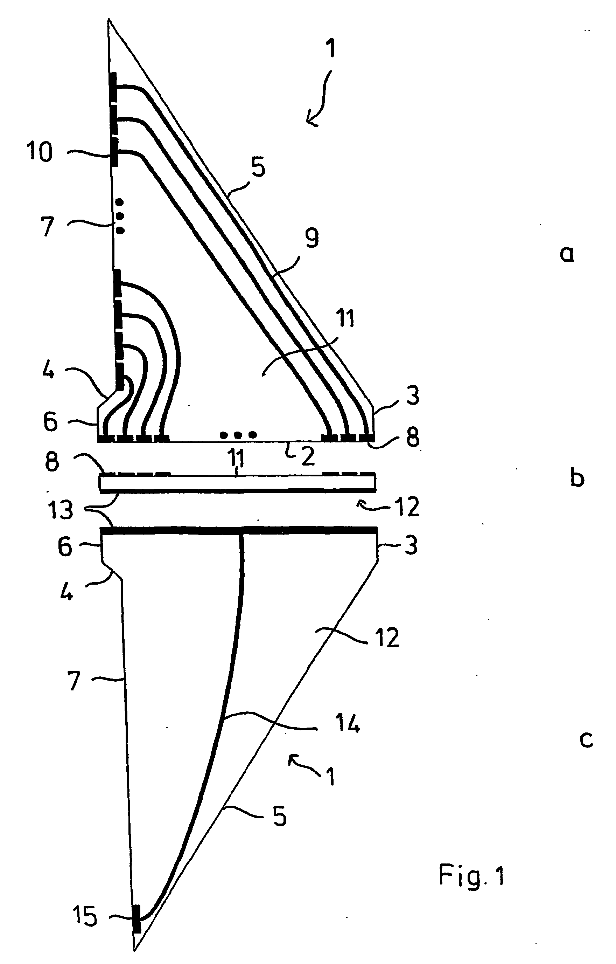

Der in der Figur 1 dargestellte Kunststofffolien-Zuschnitt 1 weist in der Draufsicht eine Stirnseite 2, daran anschließende sich nach hinten rechtwinklig weg erstreckende Seiten 3, 4 und eine schräge, die beiden Seiten 3 und 4 verbindende Rückseite 5 auf. Die Rückseite 5 kann je nach optischen Erfordernissen für die Hintergrundbeleuchtung einen Radius aufweisen, um zusammen mit den anderen aufeinanderliegenden Folien eine konkave Ausbildung zu realisieren, in deren Brennpunkt dann die Hintergrundbeleuchtung angeordnet wird. In dem Ausführungsbeispiel weist die Seite 4 einen ersten Bereich 6 und einen daran anschließenden zurückgesetzten zweiten Bereich 7 auf. Die Seite 3 und der erste Bereich 6 sind zu der Stirnseite rechtwinklig angeordnet, um später nach dem Zusammensetzen zu einem Stapel als Anschlagfläche für benachbarte Stapel zu dienen. Der zweite Bereich 7 kann auch schräg zu dem ersten Bereich 6 verlaufen. Durch den Versatz des zweiten Bereiches 7 gegenüber dem ersten Bereich 6 entsteht ein Freiraum zur Unterbringung weiterer Anschlusselemente, wie später noch gezeigt und erläutert wird.

In der Draufsicht gemäß Figur 1a befinden sich an der Stirnseite über den gesamten Bereich Anschlussflächen 8, deren jeweilige Breite der Größe des jeweiligen Bildpunktes entspricht. Von diesen Anschlussflächen führen elektrische Verbindungsleitungen 9 zu den Stirnseiten-Anschlüssen 10 an dem Rand des Kunststofffolien-Zuschnitts 1 im zweiten Bereich 7 der Seite 4. Die Leiterbahnen 9 auf dem Kunststofffolien-Zuschnitt 1 können durch verschiedene geeignete Verfahren hergestellt werden. Beispielsweise ist es möglich, die Folie mit einem leitfähigen Material im Siebdruck zu bedrucken, zuerst ein leitfähiges Material auf die Folie aufzuziehen oder aufzudampfen und anschließend über ein Ätzprozess die Leiterbahnen abzubilden, die Leiterbahnen mit einem leitfähigen Material zu prägen, leitfähiges Material mittels eines Lasers einzubrennen oder mittels Funkenerosion die Leiterbahnen einzubringen. Auch ist es möglich, die Leiterbahnen mittels Softlithografie herzustellen.

Zusätzlich kann, wenn es erforderlich ist, zu der jeweiligen Leiterbahn 9 noch ein Speicherelement für jeden Punkt auf der Folie aufgebracht werden. Hierzu kann beispielsweise ein Metall-Isolator-Metallelement (MIM-Element) als Speicherelement verwendet werden. Um die Anzahl der Stirnseiten-Anschlüsse 10 (Pads) zum Anschluss an die Steuerelektronik zu verringern kann alternativ auch auf der Folie ein intelligenter Chip platziert werden, welcher auf der Ausgangsseite alle Anschlussflächen 8 ansteuern kann und auf der Eingangsseite mit nur wenigen Versorgungs-, Steuer- und Datenleitungen auskommt. Dieser Chip könnte ggf. auch die vorstehend genannte Speicherzelle (Transistor + Kondensator) ersetzen. Ggf. kann der Kunststofffolien-Zuschnitt 1 eine eingeprägte Vertiefung zur Aufnahme des Chips aufweisen bzw. in der darüberliegenden Folie eine Aussparung vorgesehen sein.

Für die Funktionsfähigkeit des Bildschirm-Elements ist zumindest die Anordnung von Flüssigkristall in der bekannten Art und Weise an der Vorderseite der Displayfläche notwendig. Alternativ kann jedoch auch das Flüssigkristall in die Folie eingearbeitet werden, so dass anstelle der Anschluss-Fläche 8 an geeigneter Stelle ein Loch in die Folie eingestanzt wird. Dieses Loch wird später mit einem Flüssigkristall gefüllt und die Ansteuerung des Flüssigkristalls erfolgt über die darunter und darüber liegende Folie.

Der Kunststofffolien-Zuschnitt 1 kann auch aus zusammengesetzten Längsstreifen bestehen. Dies kann je nach Art des Flüssigkristalls notwendig werden, wenn ein Polarisator in die Folie eingearbeitet werden muss. Je nach Art der Ansteuerung kann dabei auch entweder die Folie selbst eingefärbt oder ein Folienstreifen mit entsprechender Farbe eingearbeitet werden. Dabei kann es sich auch um einen durchsichtigen Streifen handeln, der die einzelnen Bildpunkte optisch voneinander trennen kann. Die Zusammensetzung der Folie kann dabei soweit gehen, dass ein Streifen der Folie bereits über die gesamte Logik und Ansteuerung für einen Punkt verfügt und dann diese Punkte nur noch zusammengebracht werden müssen.

In der Figur 1b zeigt die Stirnansicht die Stirnseite 2 des Kunststofffolien-Zuschnitts 1 mit der Oberseite 11 und der Unterseite 12. Die Oberseite 11 enthält die im Zusammenhang mit der Figur 1a diskutierten Anschluss-Flächen 8, Leiterbahnen 9 und Stirnseiten-Anschlüsse 10. Auf der Unterseite 12 befindet sich im Bereich der Stirnseite 2 eine Metallisierung 13, die wie in der Figur 1c dargestellt, über eine Leiterbahn 14 zu einem Masseanschluss 15 auf der Unterseite führt.

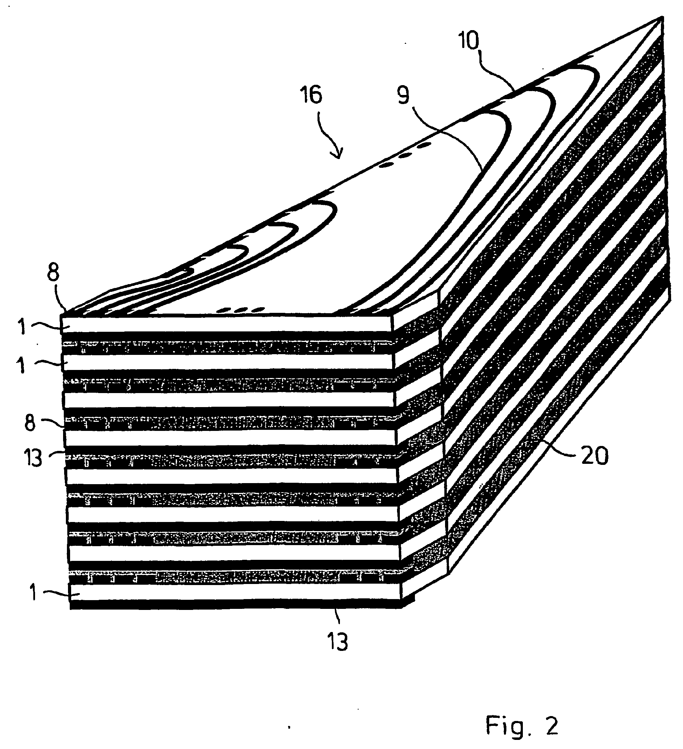

Figur 2 zeigt ein Bildschirm-Element 16 das aus mehreren zueinander gestapelten Kunststofffolien-Zuschnitten 1 gemäß der Figur 1 besteht. Die einzelnen Kunststofffolien-Zuschnitte sind mittels eines Klebers 20 miteinander verklebt.

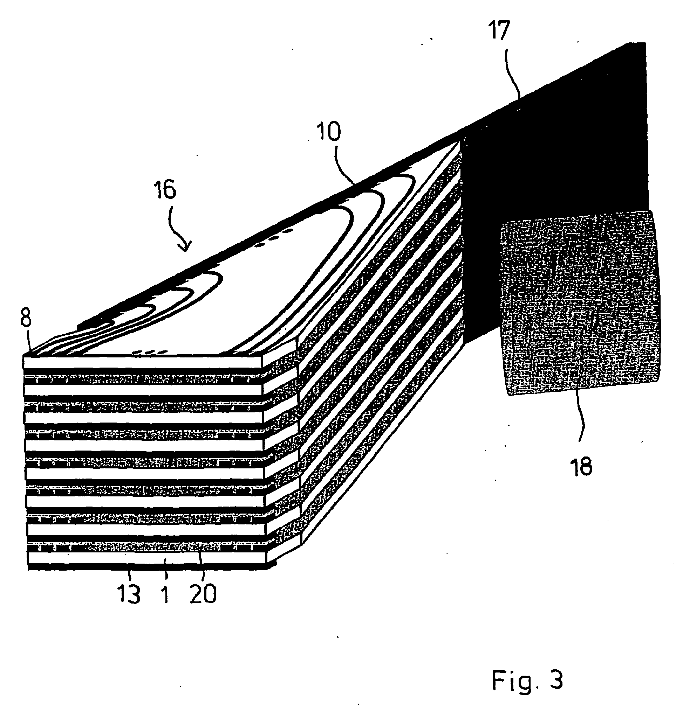

In der Figur 3 ist das Bildschirm-Element 16 zusammen mit einer AnschlussPlatine 17 dargestellt, die in dem durch den Versatz des zweiten Bereichs 7 der Seite 4 entstandenen Freiraum eingelegt ist und die einzelnen Kunststofffolien-Zuschnitte 1 an den Stirnseiten-Anschlüssen kontaktiert. Der Schaltungsträger weist die entsprechende Ansteuerungselektronik für dieses LCD-Bildelement auf. In der Figur 3 ist schematisch die Hintergrundbeleuchtung 18 angedeutet.

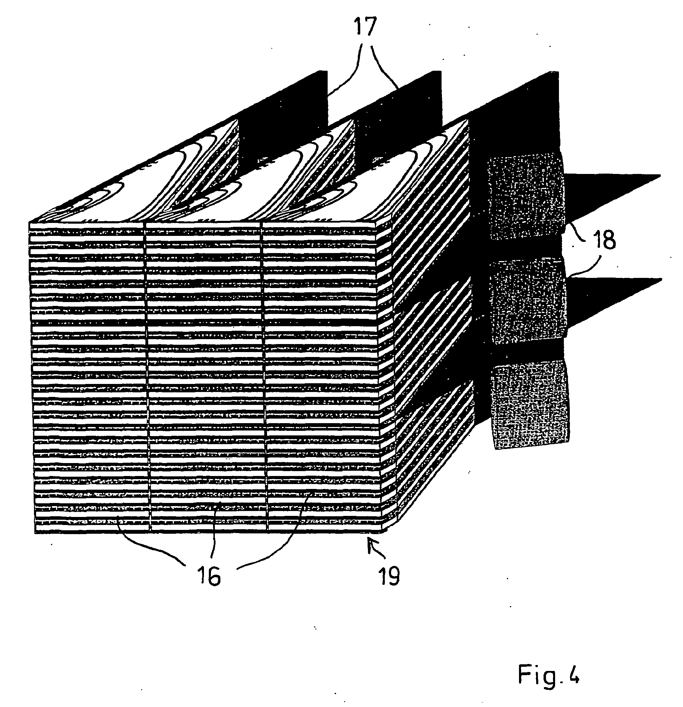

Figur 4 zeigt eine LCD-Bildfläche 19 die aus neun Bildschirm-Elementen 16 gebildet wird, wobei sich jedes Bildschirm-Element wiederum aus acht Kunststofffolien-Zuschnitten zusammensetzt. Jedem Bildschirm-Element 16 ist eine Hintergrundbeleuchtung 18 zugeordnet. Die LCD-Fläche 19 weist keine sichtbaren Trennungen zwischen den einzelnen Bildpunkten auf. Vor diese Bildfläche muss zur Erstellung eines entsprechend gewünschten Großdisplays noch eine Halterung (Rahmen) mit Abstandhaltern und Frontplatten usw. vorgesehen werden. Dies entspricht der bisher üblichen bekannten Technik.

Grundsätzlich gibt es bei der Art des Flüssigkristalls verschiedene Möglichkeiten, die auch den Aufbau bzw. die Ausbildung des Kunststofffolien-Zuschnitts oder/und die Ansteuerung des jeweiligen Bildschirm-Elements 16 zu ändern. So ist es beispielsweise möglich, organische LED's zu verwenden. Dieses Material leuchtet selbst, so dass es keiner Hintergrundbeleuchtung bedarf. Je nach Material leuchtet dieses bereits in der gewünschten Farbe oder es ist ein zusätzliches Farbfilter für die entsprechenden Bildpunkte nötig. Die Ausbildung des Kunststofffolien-Zuschnitts und der Aufbau übemimmt hier nur die reine Ansteuerung der LED.

Der gesamte Bildschirm kann entweder reflektierend oder durchleuchtend ausgebildet sein. Dementsprechend kann eine Anpassung des Kunststofffolien-Zuschnitts notwendig werden, um einen oder mehrere Polarisatoren aufzunehmen. Auch kann ein Flüssigkristall für den sogenannten IPS-Mode (Inplane Switching Mode) verwendet werden, bei dem die Kontakte des Schalters in einer Ebene liegen.

Wie bereits angedeutet, kann je nach verwendetem Flüssigkristall die eine oder andere Ansteuerung notwendig bzw. möglich sein. Dies reicht von keiner Hintergrundbeleuchtung bei Reflektion über eine monochrome Hintergrundbeleuchtung, bei der drei Bildpunkte angesteuert werden, bis zu einer farbveränderten Hintergrundbeleuchtung. Im Fall von keiner und monochromer Hintergrundbeleuchtung übernimmt die Ansteuerung nur die Aktivierung der Bildpunkte, was nach den bisher bekannten Methoden erfolgen kann.

Bei einer farbveränderten Hintergrundbeleuchtung wird nacheinander jeder Bildpunkt eines Bildschirm-Elements für kurze Zeit auf "durchsichtig geschaltet" und dazu die Hintergrundbeleuchtung mit der gewünschten Farbe und Intensität dieses Bildpunktes eingestellt. So kann beispielsweise die Hintergrundbeleuchtung mit roten, grünen und blauen LED's im entsprechend richtigen Mischungsverhältnis realisiert werden. Je mehr Bildpunkte ihre Beleuchtung von einer Hintergrundbeleuchtung erhalten, umso schneller muss jeder Bildpunkt aktiviert werden können.

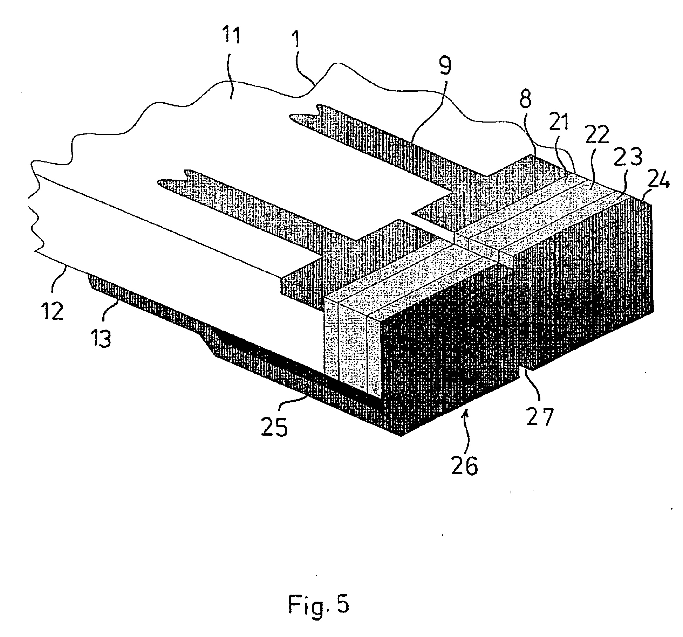

Bei der Ausführungsform gemäß Figur 5 muss der Kunststoff-Folienzuschnitt nicht mehr eine Form aufweisen, wir sie in Figur 1 dargestellt ist, da keine Hintergrundbeleuchtung mehr benötigt wird und daher die Ansteuerungselektronik nicht mehr an der Seite sondern direkt auf der Rückseite des Bildschirm-Elements Platz findet. Dort kann entweder eine Platine oder ein Chip mit dem Element verbunden werden. Der Kunststoff-Folienzuschnitt hat damit einfach nur eine rechteckige Form. Auch bei dieser Ausführungsform besteht die Möglichkeit, auf der Folienoberfläche Transistoren oder einen Chip aufzubringen, insoweit dies wirtschaftlich lohnend ist. Weiterhin besteht die Möglichkeit, diese Transistoren bzw. eine Gesamtschaltung aus Polymertransistoren (Plastik-Transistoren) aufzubauen bzw. aufzudrucken.

Der Kunststofffolien-Zuschnitt 1 weist, entsprechend der im Ausführungsbeispiel von Figur 1 auf der Oberseite 11 Anschlussflächen 8 auf, die über Verbindungsleitungen 9 ansteuerbar sind. An der Stirnseite 2 der Kunststofffolie befindet sich eine erste elektrisch leitende Schicht 21 und eine zweite elektrisch leitende Schicht 23 zwischen denen eine OLEP-Schicht 22 angeordnet ist. Diese beiden elektrisch leitenden Schichten 21, 23 bilden die Anode und die Katode für die OLEP-Schicht 22. Als Masseanschluss dient eine weitere elektrisch leitende Schicht 24 auf der elektrisch leitenden Schicht 23, die in Verbindung mit der Metallisierung 13 auf der Unterseite 12 als gemeinsamer Masseanschluss dient, wobei im Bereich der Stirnseite 2 die Metallisierung 13 durch eine Isolationsschicht 25 von den Schichten 21, 22 und 23 getrennt ist. Die äußere elektrisch leitende Schicht 24 ermöglicht es, jeder Folie eine eigene Masse zur Verfügung zu stellen. Dadurch gehören zu jeder Masse nur relativ wenige Bildpunkte, beispielsweise 256, so dass bei dieser geringen Anzahl von Bildpunkten für jede Folie eine passive Matrix realisiert werden kann. Dies ist bei den bisher bekannten Aufbauten nicht möglich, da die Größe der passiven Matrix infolge der mit der Größe des Bildschirms steigenden Multiplexrate zunimmt. Wenn die Multiplexrate erhöht wird, also die Leuchtdauer innerhalb einer bestimmten Bildaufbauzeit verringert wird, dann muss das OLEP mit einer höheren Spannung betrieben werden. Irgendwann ist der Punkt erreicht, an dem die hohen Spannungen entweder ein Übersprechen auf die benachbarten Bildschirmpunkte bewirkt oder das OLEP aufgrund zu hoher Impulsleistungen zerstört wird. Um dies zu vermeiden, wird eine aktive Matrix verwendet, bei der sich an jedem Kreuzungspunkt, wie oben erwähnt, ein Transistor befindet, der die eigentliche Leistung schaltet und dadurch ein Übersprechen auf Grund hoher Spannungen bei hoher Multiplexrate verhindert. Die Zerstörung des OLEP bei zu hoher Impulsleistung kann damit jedoch nicht beseitigt werden. Durch den vorstehend beschriebenen Aufbau mit der elektrisch leitenden Schicht 24 wird dies verhindert. Des weiteren kann bei einer passiven Matrix mit dem beschriebenen Aufbau innerhalb einer Zeile die Reihenfolge der Ansteuerung der Bildpunkte viel einfacher variiert werden als bei einer aktiven Matrix, bei der der Aufbau der Bildpunkte daher üblicherweise zeilenweise nacheinander erfolgt.

In der vergrößerten Darstellung gemäß Figur 5 ist der Aufbau nur schematisch, ohne Rücksicht auf die Größenverhältnisse dargestellt. Die Dicke der Kunststofffolie für den Kunststofffolien-Zuschnitt 1 beträgt ca. 100 µm, die der Verbindungsleitung 9 ca. 30 - 40 µm. Ein Bildpunkt hat eine Breite von ca. 300 µm und der Schnitt 27 zwischen zwei Bildpunkten 26 hat eine Breite von ungefähr 30 µm. Die Schichten 21 - 24 haben dem gegenüber typischer Weise eine Dicke von 20-100 nm und sind damit um den Faktor 1000 kleiner.

Da bei einem OLEP-Bildschirm das OLEP selbst leuchtet, wird dieser nicht von hinten durchleuchtet. Die Schichten 21 - 24 auf der Stirnseite 2 sind so dünn, dass sie immer noch durchsichtig sind. Um hier einen hohen Kontrast zu erhalten, wird vorzugsweise die Kunststofffolie in einem tiefen Schwarz gewählt, damit ein nichtleuchtender Punkt ein tiefes Schwarz erhält.

Die drei Grundfarben des Bildschirms können auf unterschiedliche Weise realisiert werden, wobei, egal, wie die Farben realisiert werden, immer drei, in der Farbwirkung unterschiedliche Folien aufeinander geklebt werden, welche dann zusammen eine Reihe von Bildpunkten ergeben. Daher ist auch eine Folie nur 100 µm dick und ein Bildpunkt-Anschluss 8 300 µm breit, um einen quadratischen Farbbildpunkt herzustellen. Zur Erzeugung eines Farbbildpunktes kann entweder jede Farbe (rot, grün, blau) eine bestimmte Art von OLEP für den jeweiligen Bildpunkt verwendet werden. Eine andere Möglichkeit besteht darin, eine bestimmte OLEP-Farbe zu wählen, beispielsweise weiß, und auf die elektrisch leitende Masseschicht 24 eine entsprechende gefärbte Schutzschicht (nicht dargestellt) aufzubringen. Diese Schutzschicht ist ohnehin erforderlich, um eine Oxidation des OLEP zu verhindern. Es wird dann daher anstatt eines klar durchsichtigen Flüssigkunststoffes ein farblich modifizierter Kunststoff verwendet. Die Stärke dieser ebenfalls transparenten Schutzschicht liegt im µm-Bereich und wird zweckmäßiger Weise auch nach der Vervollständigung des gesamten Bildschirms aus verschiedenen Bildschirm-Elementen über die gesamte Bildschirmfläche zusätzlich aufgetragen. Die Herstellung eines Bildschirmelements gemäß Figur 5 erfolgt derart, dass mehrere mit den Anschlussflächen 8 und elektrischen Verbindungsleitungen 9 versehene Kunststofi-Folienzuschnitte 1 zu einem Block aus losen, nicht miteinander verklebten Kunststofffolien-Lagen zusammengelegt werden. Die Herstellung der elektrischen Verbindungsleitungen 9 auf der Kunststofffolie kann dabei derart erfolgen, dass die Folien auf Maß gestanzt und die Verbindungsleitungen 9 mittels Siebdruck aufgebracht werden. Für die weiter Automation können die Verbindungsleitungen 9 im Durchlauf auf die Folien im Softlithografie-Verfahren aufgeprägt, anschließend die so entstandenen Kapillare mit Leitsilber gefüllt, getrocknet und die Folien auf Maß ausgestanzt werden. Eine andere Möglichkeit besteht darin, flüssigen Kunststoff in eine Form zu pressen, wodurch der Folienzuschnitt mit seinen Kapillaren entsteht. Anschließend werden die Kapillaren wieder mit Leitsilber gefüllt und getrocknet.

Nachdem die Folien bei einem Block zusammengefasst sind, wird die Stirnseite 2 des Blocks plan geschliffen und gereinigt. Um die Rauhigkeit der Stirnkante auf einige nm herabzusetzen, kann gegebenenfalls die Stirnseite an einer heißen Platte leicht angeschmolzen werden. Gegebenenfalls wird die Stirnfläche in einem Plasma gereinigt bzw. aktiviert, um die Haftung der nachfolgenden Schichten zu verbessern.

Im Anschluss daran wird auf die Stirnfläche des Blocks die elektrisch leitende Schicht 21 mittels Sputtern Aufdampfen oder Spin-Coaten hergestellt. Das Material variiert je nach verwendetem OLEP und kann, wenn das OLEP dies erfordert, auch gedopt sein. Die Schichtdicke sollte ausreichend leitend und noch durchsichtig sein und in dem vorstehend erwähnten Stärkenbereich liegen. Anschließend wird auf die Stirnfläche des Blocks die OLEP-Schicht, beispielsweise durch Spin-Coaten aufgebracht und getrocknet. Andere Möglichkeiten bestehen im Ink-Jet-Printing oder gegebenenfalls auch Print-Coating besprühen oder Dippen. Dann wird die zweite elektrisch leitende Schicht 23 entsprechend wie die erste elektrisch leitende Schicht 21 aufgebracht. Bis hierher waren die Folien noch in einer Vorrichtung als Block gespannt. Sie werden jetzt vereinzelt und von- einander getrennt und im Folgenden einzeln weiter verarbeitet.

Bei jeder einzelnen Folie werden die Schichten 21 - 23 auf der Unterseite 12 der Folie durch eine Isolierschicht 25 isoliert, die gesputtert oder aufgedampft wird. Dann wird die Masselage 24 (Metallisierung 13) auf der Unterseite 12 und der Stirnseite 2 aufgesputtert oder aufgedampft. Mit einem Sägeschnitt senkrecht zur Stirnseite 2 werden die einzelnen Bildpunkte hergestellt und durch den Schnittspalt 27 getrennt.

Zur Vermeidung der Oxidation werden die hergestellten Bildpunkschichten mit einer Schutzschicht überzogen. Die Schutzschicht kann ebenfalls entweder eine gesputterte oder aufgedampfte Schicht sein. Ein Aufbringen durch Eintauchen in eine Flüssigkunststoff ist ebenfalls möglich.

Jetzt erst werden die Folien zu einem Bildschirmelement entsprechend Figur 2 verklebt. Die einzelnen Bildschirmelemente werden dann zu dem eigentlichen Bildschirm in der gewünschten Größe zusammengestellt und miteinander verklebt. Zur Vervollständigung benötigt dieser noch einen Rahmen, eine vordere Schutzscheibe und ein hinteres Gehäuse.

Mittels der vorstehend der beschriebenen Erfindung ist es somit möglich, ein hochauflösendes Großdisplay ohne Unterteilung der Bildfläche herzustellen.

## Patentansprüche

1. Büdschirmelement bestehend aus einem Stapel von mehreren flächig aufeinander liegenden Kunststofffoüen-Zuschnitten (1) mit
einer die vordere sichtbare Displayfläche formenden Stirnseite (2), von der Stirnseite sich nach hinten weg erstreckenden Seiten (3, 6) und einer die Seiten verbindenden Rückseite (5);
einer Metallisierungsschicht (13, 14) auf einer ersten Flachseite (12) wenigstens im Bereich der Stirnseite (2);
metallischen, voneinander beabstandeten und getrennt elektrisch ansteuerbaren Anschluss-Flächen (8) auf der gegenüberliegenden zweiten Flachseite (11) wenigstens im Bereich der Stirnseite (2), wobei die Größe der Anschluss-Flächen (8) der Größe des jeweiligen Bildpunktes entspricht;
elektrischen Verbindungsleitungen (9, 14) von den Anschlussflächen (8) auf den Flachseiten (11, 12) zu den Rändern der sich nach hinten von der Stirnseite weg erstreckenden Folienseiten (3, 6) und/oder der Rückseite (5);
und elektrischer Kontaktierung der auf den einzelnen Kunststofffolien-Zuschnitten (1) angeordneten Anschluss-Flächen (8) mit einer Ansteuerungselektronik auf einer gegenüber der Seitenkante der Stirnseite (2) zurückgesetzten Folienseite (3, 6) und/oder auf der Rückseite (5),
wobei die Stirnseiten (2) der gestapelten Kunststofffolien-Zuschnitte (1) die maximale Höhe und Breite des Bildschirmelements einschließlich der zugehörigen Ansteuerungselektronik bestimmen und **dadurch** an jeder Kante der Displayfläche ein oder mehrere Bildschirmelemente direkt ohne bei Betrieb sichtbaren Abstand anordenbar sind.

2. Bildschirmelement nach Anspruch 1, **dadurch gekennzeichnet, dass** die Kunststofffolien-Zuschnitte (1) aus lichtdurchlässigem Kunststoff hergestellt sind.

3. Bildschirmelement nach Anspruch 1 oder 2, **dadurch gekennzeichnet, dass** die Seiten (3, 4) unterschiedlich lang ausgebildet sind.

4. Bildschirmelement nach einem der vorangegangen Ansprüche, **dadurch gekennzeichnet, dass** mindestens eine Seite (4) einen ersten, an die Stirnseite angrenzenden Seitenbereich (6) und einen daran in Richtung der anderen Seite (3) versetzten oder zu dem ersten Seitenbereich schräg verlaufenden zweiten Seitenbereich (7) aufweist

5. Bildschirmelement nach Anspruch 4, **dadurch gekennzeichnet, dass** die externen Anschlüsse (10) für die Stirnseitenanschlüsse (8, 13) an dem zweiten Seitenbereich (7) angeordnet sind und mit entsprechenden Anschlüssen auf einem an diesen Seitenbereich anliegenden Schaltungsträger (17) mit einer Ansteuerungselektronik für diesen Bildpunkt verbunden sind.

6. Bildschirmelement nach Anspruch 1, **dadurch gekennzeichnet, dass** zur Erzeugung der einzelnen Bildpunkte die Stirnseite (2) jeder Kunststofffolie der Breite der Anschlussflächen (8) entsprechend, zwei elektrisch leitende Schichten (21, 24) aufweist, zwischen denen eine lichtemittierende Schicht (22) angeordnet ist, wobei die innere Schicht (21) die metallischen Anschlussflächen (8) und die äußere Schicht die Metallisierungsschicht (13) elektrisch kontaktiert.

7. Bildschirmelement nach Anspruch 6, **dadurch gekennzeichnet, dass** die lichtemittierende Schicht (22) ein organisches lichtemittierendes Polymer ist.

8. Bildschirmelement nach Anspruch 6 oder 7, **dadurch gekennzeichnet, dass** auf die äußere elektrisch leitende Schicht (23) die jeweilige Metallisierungsschicht (24) aufgebracht ist, die auf der ersten Flachseite (12) als gemeinsamer Masse der einzelnen Bildpunkte zusammengeführt ist.

9. Bildschirmelement nach Anspruch 6 bis 8, **dadurch gekennzeichnet, dass** jeweils die einzelnen übereinander befindlichen Bildpunkte (26) von drei übereinanderliegenden Folien (1) einen Farbbildpunkt bilden, wobei die einzelnen Bildpunkte eines Farbbildpunktes die drei Grundfarben rot, grün, blau aufweisen.

10. Bildschirm-Fläche für einen hochauflösenden Bildschirm, **dadurch gekennzeichnet, dass** sie mehrere Bildschirmelemente (16) gemäß einem der vorangegangenen Ansprüche aufweist.

## Claims

1. A screen element comprising a stack of a plurality of plastic film blanks (1) lying on the top of the other in a planer manner having
an end side (2) forming the front visible display area, sides (3, 6) extending away toward the rear from the end side, and a rear side (5) connecting the sides;
a metallization layer (13, 14) on a first flat side (12) at least in the region of the end side (2);
metallic pads (8) on the opposite second flat side (11) at least in the region of the end side (2), which pads are spaced apart from one another and can be electrically driven separately, the size of the pads (8) corresponding to the size of the respective pixel; and
electrical connecting lines (9, 14) from the pads (8) on the flat sides (11, 12) to the edges of the film sides (3, 6) extending from the end side toward the rear, and/or the rear side (5);
and electrical contact connection of the pads (8) arranged on the individual plastic film blanks (1) to drive electronics on a film side (3, 6) set back relative to the side edge of the end side (2) and/or on the rear side (5),
the end sides (2) of the stacked plastic film blanks (1) determining the maximum height and width of the screen element including the associated driving electronics and, as a result, it being possible to arrange at each edge of the display area, one or more screen elements directly without a spacing that is visible during operation.

2. The screen element as claimed in claim 1, **characterized in that** the plastic film blanks (1) are produced from light-transmissive plastic.

3. The screen element as claimed in claim 1 or 2, **characterized in that** the sides (3, 4) are formed with different lengths.

4. The screen element as claimed in one of the preceding claims, **characterized in that** at least one side (4) has a first side region (6), which adjoins the end side, and a second side region (7), which is offset thereto in the direction of the other side (3) or runs obliquely with respect to the first side region.

5. The screen element as claimed in claim 4, **characterized in that** the external terminals (10) for the end side terminals (8, 13) are arranged at the second side region (7) and are connected to corresponding terminals on a circuit carrier (17), present at said side region, with driving electronics for this pixel.

6. The screen element as claimed in claim 1, **characterized in that**, in order to produce the individual pixels, the end side (2) of each plastic film has, corresponding to the width of the pads (8), two electrically conductive layer (21, 24) between which a light-emitting layers (22) is arranged, the inner layer (21) making electrical contact with the metallic pads (8) and the outer layer making electrical contact with the metallization layer (13).

7. The screen element as claimed in claim 6, **characterized in that** the light-emitting layer (22) is an organic light-emitting polymer.

8. The screen element as claimed in claim 6 or 7, **characterized in that** the respective metallization layer (24) is applied to the outer electrically conductive layer (23), which metallization layer is combined on the first flat side (12) as common ground of the individual pixels.

9. The screen element as claimed in claim 6 to 8, **characterized in that** the individual pixels (26) situated one above the other of three films (1) lying one above the other in each case form a color pixel, the individual pixels of a color pixel having the three primary colors, red, green, blue.

10. A screen area for a high-resolution screen, **characterized in that** it has a plurality of screen elements (16) as claimed in one of the preceding claims.

## Revendications

1. Elément d'écran composé d'une pile de plusieurs découpes de film en matière plastique (1) superposées en nappes avec
une face frontale (2) qui forme la surface d'affichage avant visible, des côtés (3, 6) qui s'étendent de la face frontale vers l'arrière et une face arrière (5) qui relie les côtés ;
une couche de métallisation (13, 14) sur une première face plate (12) au moins dans la zone de la face frontale (2) ;
des surfaces de raccordement (8) métalliques, espacées les unes des autres et pouvant être amorcées électriquement de manière séparée sur la deuxième face plate (11) située en face au moins dans la zone de la face frontale (2), la taille des surfaces de raccordement (8) correspondant à la taille du point d'image respectif ;
des lignes de jonction électriques (9, 14) allant des surfaces de raccordement (8) situées sur les faces plates (11, 12) aux bords des côtés des films (3, 6) qui s'étendent vers l'arrière en partant de la face frontale et/ou à la face arrière (5) ;
et avec un contact électrique entre les surfaces de raccordement (8) disposées sur les différentes découpes de film en matière plastique (1) et une électronique d'amorçage sur une face de film (3, 6) en retrait par rapport à l'arête latérale de la face frontale (2) et/ou sur la face arrière (5),
les faces frontales (2) des découpes de film en matière plastique empilées (1) déterminant la hauteur et la largeur maximales de l'élément d'écran, y compris l'électronique d'amorçage afférente, et un ou plusieurs éléments d'écran pouvant être de ce fait disposés directement sur chaque arête de la surface d'affichage sans écart visible pendant le fonctionnement.

2. Elément d'écran selon la revendication 1, **caractérisé en ce que** les découpes de film en matière plastique (1) sont en matière plastique translucide.

3. Elément d'écran selon la revendication 1 ou 2, **caractérisé en ce que** les côtés (3, 4) ont des longueurs différentes.

4. Elément d'écran selon l'une quelconque des revendications précédentes, **caractérisé en ce qu'**au moins un côté (4) comporte une première zone latérale (6) adjacente à la face frontale et une deuxième zone latérale (7) décalée en direction de l'autre côté (3) ou oblique par rapport à la première zone latérale.

5. Elément d'écran selon la revendication 4, **caractérisé en ce que** les raccords externes (10) pour les raccords des faces frontales (8, 13) sont disposés sur la deuxième zone latérale (7) et reliés à une électronique d'amorçage pour ce point d'image avec des raccords correspondants sur un support de circuits (17) adjacent à cette zone latérale.

6. Elément d'écran selon la revendication 1, **caractérisé en ce que**, pour générer les différents points d'image, la face frontale (2) de chaque film en matière plastique comporte, du fait de la largeur des surfaces de raccordement (8), deux couches électroconductrices (21, 24) entre lesquelles une couche électroluminescente (22) est disposée, la couche intérieure (21) étant en contact électrique avec les surfaces de raccordement métalliques (8) et la couche extérieure avec la couche de métallisation (13).

7. Elément d'écran selon la revendication 6, **caractérisé en ce que** la couche électroluminescente (22) est un polymère organique électroluminescent.

8. Elément d'écran selon la revendication 6 ou 7, **caractérisé en ce que** la couche de métallisation respective (24) qui est réunie sur la première face plate (12) comme masse commune des différents points d'image est posée sur la couche extérieure électroconductrice (23).

9. Elément d'écran selon les revendications 6 à 8, **caractérisé en ce que** les différents points d'image (26) respectivement superposés de trois films (1) superposés forment un point d'image en couleur, les différents points d'image d'un point d'image en couleur comportant les trois couleurs de base rouge, vert, bleu.

10. Surface d'écran pour un écran à haute résolution, **caractérisée en ce qu'**elle comporte plusieurs éléments d'écrans (16) selon l'une quelconque des revendications précédentes.
